# EUROPÄISCHE PATENTSCHRIFT

(11) **EP 4 114 691 B1**
(45) Veröffentlichungstag und Bekanntmachung des Hinweises auf die Patenterteilung: **24.01.2024**
(21) Anmeldenummer: 21711485.9
(22) Anmeldetag: 03.03.2021
(51) Int. Cl.: B60R 16/033, G01R 31/382

(54) **VERFAHREN ZUM BETREIBEN EINES BORDNETZES**
METHOD FOR OPERATING A VEHICLE ELECTRICAL SYSTEM
PROCÉDÉ PERMETTANT DE FAIRE FONCTIONNER UN RÉSEAU DE BORD

(30) Priorität: 05.03.2020 DE 102020105909
(43) Veröffentlichungstag der Anmeldung: 11.01.2023
(73) Patentinhaber: Robert Bosch GmbH, 70469 Stuttgart (DE); Audi AG, 85045 Ingolstadt (DE)
(72) Erfinder: MOTZ, Juergen, 71711 Steinheim An Der Murr (DE); DRAESE, Nils, 70469 Stuttgart (DE); KOLLER, Oliver Dieter, 71384 Weinstadt (DE); VAN BERGEN, Patrick, 70825 Korntal-Muenchingen (DE); KASPAR, Sebastian, 85051 Ingolstadt (DE); HEIDINGER, Frederic, 73728 Esslingen (DE); BLACH, Marco, 71272 Renningen (DE); WOERZ, Markus, 71229 Leonberg (DE); SCHNEIDER, Martin, 85098 Großmehring (DE)
(74) Vertreter: RDL Patentanwälte PartG mbB
(86) Internationale Anmeldenummer: PCT/EP2021/055367
(87) Internationale Veröffentlichungsnummer: WO 2021/175936

(56) Entgegenhaltungen:
- DE-A1-102011 080 603
- DE-A1-102014 017 569
- DE-A1-102018 212 372

## Beschreibung

Die Erfindung betrifft ein Verfahren zum Betreiben eines Bordnetzes und ein solches Bordnetz.

### Stand der Technik

Unter einem Bordnetz , wie z.B. in DE102018212372 beschrieben, ist im automotiven Einsatz die Gesamtheit aller elektrischen Komponenten in einem Kraftfahrzeug zu verstehen. Somit sind davon sowohl elektrische Verbraucher als auch Versorgungsquellen, wie bspw. Batterien, umfasst. Man unterscheidet dabei zwischen dem Energiebordnetz und dem Kommunikationsbordnetz, wobei hierin vor allen Dingen auf das Energiebordnetz eingegangen wird, das dafür zuständig ist, die Komponenten des Kraftfahrzeugs mit Energie zu versorgen. Zur Steuerung des Bordnetzes ist üblicherweise ein Mikrocontroller vorgesehen, der neben Steuerungsfunktionen auch Überwachungsfunktionen ausführt.

In einem Kraftfahrzeug ist darauf zu achten, dass elektrische Energie so verfügbar ist, dass das Kraftfahrzeug jederzeit gestartet werden kann und während des Betriebs eine ausreichende Stromversorgung gegeben ist. Aber auch im abgestellten Zustand sollen elektrische Verbraucher noch für einen angemessenen Zeitraum betreibbar sein, ohne dass ein nachfolgender Start beeinträchtigt wird.

Aufgrund der zunehmenden Elektrifizierung von Aggregaten sowie der Einführung von neuen Fahrzeugfunktionen, wie bspw. einem teil-, hoch- oder vollautomatisierten Fahren, steigt die Anforderung an die Zuverlässigkeit der elektrischen Energieversorgung im Kraftfahrzeug. Dabei ist insbesondere zu beachten, dass die Anzahl an leistungselektrischen Systemen stetig anwächst. Wenn eines dieser Systeme fehlerhaft ist oder gar ausfällt, kann es dazu kommen, dass die Bordnetzspannung außerhalb des normalen Betriebsbereichs gerät, was zu einer Beeinträchtigung des Komforts und der Sicherheit der Fahrzeuginsassen führen kann.

Beispielhafte neue Fahrfunktionen sind das automatisierte sowie das autonome Fahren. Beim automatisierten und autonomen Fahrbetrieb im Kraftfahrzeug steht der Fahrer nicht mehr als sensorische, regelungstechnische, mechanische und energetische Rückfallebene zur Verfügung. Das Fahrzeug muss seine Umwelt selbstständig erkennen, Trajektorien planen, auswählen und durch Ansteuerung der Aktoren umsetzen. Durch den Wegfall des Fahrers hat das Fahrzeug, d. h. der Hersteller, die Verantwortung für das Fahrzeugverhalten.

### Offenbarung der Erfindung

Vor diesem Hintergrund werden ein Verfahren nach Anspruch 1 und ein Bordnetz gemäß Anspruch 11 vorgestellt. Ausführungsformen ergeben sich aus den abhängigen Ansprüchen und aus der Beschreibung.

Das vorgestellte Verfahren dient zum Betreiben eines Bordnetzes, das einen Energiespeicher, bspw. eine Batterie, wobei diesem Energiespeicher eine Sensor-Recheneinheit zugeordnet ist, und einen elektronischen Leistungsverteiler bzw. Lastverteiler aufweist, wobei mit der Sensor-Recheneinheit mindestens eine Messgröße des Energiespeichers erfasst wird und unter Berücksichtigung dieser mindestens einen Messgröße ein Parameter des Energiespeichers berechnet wird. In einem ersten Schritt wird eine Plausibilisierung der mindestens einen Messgröße durchgeführt. In einem zweiten Schritt erfolgt eine Plausibilisierung der Berechnung. Hierzu wird der elektronische Lastverteiler eingesetzt.

Es kann vorgesehen sein, dass die Plausibilisierung der mindestens einen Messgröße in dem ersten Schritt einmal je Fahrzyklus und die Plausibilisierung der Berechnung im zweiten Schritt mehrmals im Fahrzyklus durchgeführt wird.

Das Verfahren sieht in Ausgestaltung eine Überwachung der Leistungsfähigkeit der Batterie mit ASIL C durch Verwendung eines elektronischen Batteriesensors (EBS) als Sensor-Recheneinheit und eines intelligenten elektronischen Leistungs- bzw. Lastverteilers vor. Ein EBS liefert Informationen über den Batteriezustand ggf. unter Berücksichtigung von Alterungseffekten. Der Leistungsverteiler hat die Aufgabe, elektrische Energie an Komponenten im Bordnetz weiterzugeben. Weiterhin ist zu beachten, dass ein elektronischer Batteriesensor (EBS) ggf. eine geforderte systematische Sicherheits-Integrität, z. B. ASIL C, oder die an ihn gestellten Hardwaremetriken nicht erreicht. Eine Plausibilisierung des EBS durch einen Leistungsverteiler stellt eine Möglichkeit zur Lösung dieses Problems dar.

Das vorgestellte Verfahren hat, zumindest in einigen der Ausführungen, eine Reihe von Vorteilen:
- Ermöglichung eines einkanaligen ASIL C Energiebordnetzes ohne zusätzliche 12V-Batterie,
- es sind keine zusätzlichen Maßnahmen im Energiebordnetz erforderlich, da ein intelligenter Leistungsverteiler aufgrund weiterer Funktionen, wie bspw. Trennung von Verbrauchern mit nicht-sicherheitsrelevanten Funktionen, usw., sowieso zu integrieren ist, oder Sicherheitsmaßnahmen, die dieselbe Funktion erfüllen.

Weitere Vorteile und Ausgestaltungen der Erfindung ergeben sich aus der Beschreibung und den beigefügten Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

Figur 1 zeigt ein Bordnetz gemäß dem Stand der Technik.
Figur 2 zeigt eine Ausführung des vorgestellten Bordnetzes.
Figur 3 zeigt eine beispielhafte Ausführung des beschriebenen Verfahrens.
Figur 4 zeigt in einem Flussdiagramm eine mögliche Plausibilisierung von EBS-Messgrößen.
Figur 5 zeigt einen Ausschnitt aus einem Bordnetz zur Verdeutlichung der Plausibilisierung von Messgrößen.
Figur 6 zeigt in einem Graphen einen beispielhaften Strompuls eines Gleichspannungswandlers.
Figur 7 zeigt in einem Flussdiagramm eine mögliche Überprüfung des Innenwiderstands einer Batterie im Bordnetz.
Figur 8 zeigt die Plausibilisierung der Berechnung des Innenwiderstands der Batterie.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

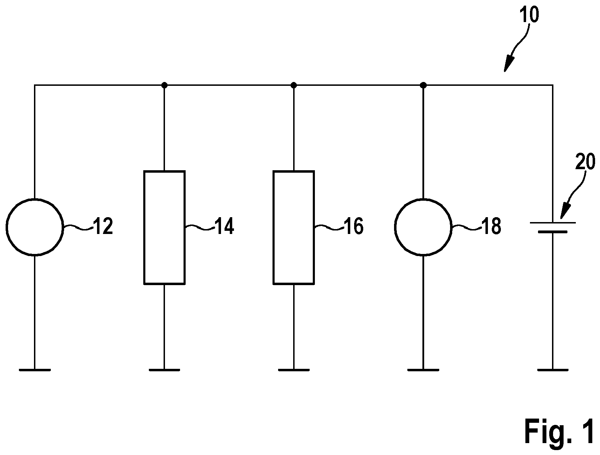

In Figur 1 ist ein beispielhaftes 12-Volt-Energiebordnetz eines Fahrzeugs für manuelles Fahren dargestellt, welches insgesamt mit der Bezugsziffer 10 bezeichnet ist. Die Darstellung zeigt als Komponenten des Bordnetzes 10 einen Generator 12, einen 12V Verbraucher R_{B,12V} 14, einen sicherheitsrelevanten Verbraucher R_{SR} 16, einen Starter S 18 und eine 12V Batterie 20.

Zu beachten ist, dass an heutige Energiebordnetze bspw. ein ASIL B auf die Versorgung der sicherheitsrelevanten Verbraucher allokiert wird. Daraus ergibt sich eine sichere Energieversorgung aus der Batterie 20 mit ASIL B.

Dabei ist jedoch zu berücksichtigen, dass die Sicherheitsanforderungen an die Energieversorgung im Fahrzeug stetig steigen. Gründe dafür sind im manuellen Fahren bspw. schwerere Fahrzeuge, z. B. BEV (Battery Electrical Vehicle: Elektrofahrzeug) mit 800 kg Batterien, bei denen eine Gesamtmasse von mehr als 3t möglich ist, oder der Trend zu größeren Fahrzeugen und der damit verbundenen schlechteren Kontrollierbarkeit des Fahrzeugs bei Verlust der Lenkunterstützung. Zur Realisierung der Brems- bzw. Lenkunterstützung wird elektrische Energie aus dem Energiebordnetz benötigt, wodurch die Anforderungen an die elektrische Energieversorgung, z. B. auf ASIL C, steigt.

Um die hohen Sicherheitsanforderungen an die Energieversorgung sicherstellen zu können, wird im Sicherheitskonzept u. a. eine bestimmte Batterie und deren zugehörige Überwachung eingesetzt. Zur Überwachung des Leistungsvermögens bzw. der Performance der Batterie wird bspw. der Innenwiderstand Rᵢ der Batterie 20 bestimmt. Mit der überwachten Batterie 20 wird sichergestellt, dass das verbleibende Risiko bspw. beim manuellen oder automatisierten Fahren unterhalb eines zulässigen Restrisikos aufgrund eines Energiebordnetzausfalls bleibt.

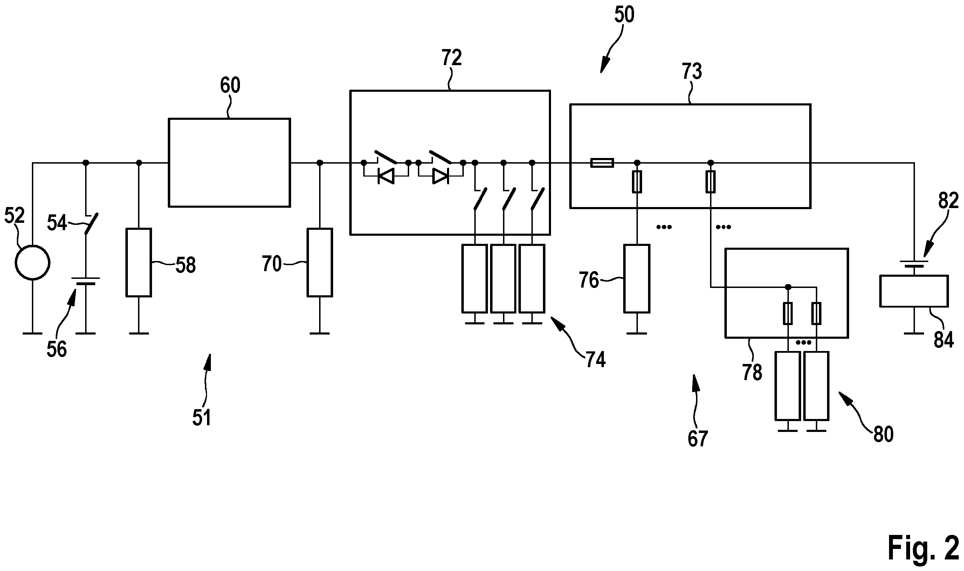

Um die sichere Energieversorgung der sicherheitsrelevanten Verbraucher, in Figur 1 der Verbraucher 16, z. B mit ASIL C sicherstellen zu können, ist der Einsatz eines EBS nicht mehr ausreichend, da dieser ggf. systematisch maximal nach ASIL B entwickelt werden kann bzw. die geforderten Hardwaremetriken mit einem EBS allein nicht erreicht werden. Um die Energiebereitstellung der Batterie nach ASIL C sicherstellen zu können, wird daher eine Ausführung eines Bordnetzes nach Figur 2 vorgestellt.

Figur 2 zeigt ein Bordnetz, das insgesamt mit der Bezugsziffer 50 bezeichnet ist. Dieses Bordnetz 50 umfasst auf einer Seite mit höherer Spannungslage 51 eine elektrische Maschine EM 52, eine Hochvolt/48V Batterie B_{HV/48V}56, einen HV/48V Verbraucher R_{B,HV/48V} 58 und einen Gleichspannungswandler 60. In Lithiumlonen-Batterien ist ein Schalter 54 zur Vermeidung von Überströmen und damit zum thermischen Eigenschutz integriert. Auf einer Seite mit niedriger Spannungslage 67 sind ein 12V Verbraucher R_{B,12V} 70, stellvertretend für die Vielzahl der 12V nicht sicherheitsrelevanten Verbraucher (NSRV), ein elektronischer Lastverteiler 72, ein konventioneller Leistungsverteiler bzw. eine Sicherungsbox 73, sicherheitsrelevante Verbraucher 74, sicherheitsrelevante Verbraucher 76, ein Unter-Leistungsverteiler 78, sicherheitsrelevante/Post Crash/NSRV Verbraucher 80, eine Batterie B₁ 82 und ein der Batterie B₁ 82 zugeordneter Sensor zur Überwachung 84 vorgesehen.

Bei dieser Ausführung wird somit die Batterieüberwachung mit ASIL C mittels des EBS 84 in Kombination mit dem intelligenten Lastverteiler (IELV) 72 durchgeführt. Es ergeben sich allerdings Schwierigkeiten bei der Überwachung des EBS 84 durch den IELV 72 im vorgestellten Bordnetz 50, das hier auch als Energiebordnetz bezeichnet wird, dadurch, dass zwischen der Batterie 82 und dem IELV 72 ein unbekannter Stromabfluss stattfindet.

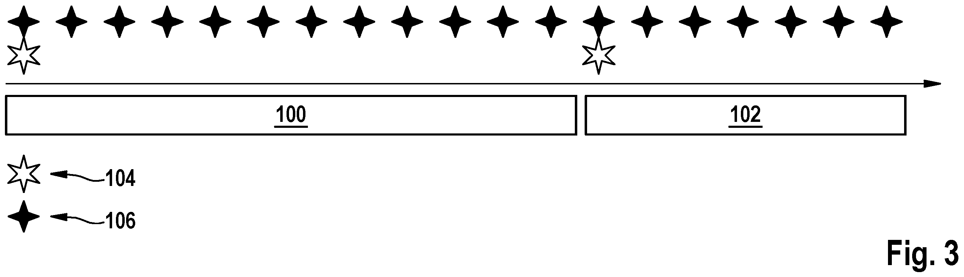

Zur Überwachung der Batterie 82 wird u. a. der Innenwiderstand Rᵢ der Batterie 82 ermittelt. Im Bordnetz 50 wird dazu der EBS 84 eingesetzt. Da der EBS 84 die systematische Sicherheitsintegrität, z. B. ASIL C, und/oder die geforderten Hardwaremetriken nicht erreicht, wird eine Plausibilisierung über den intelligenten IELV 72 durchgeführt. Durch unbekannte Abgänge zwischen der relevanten IELV-Messstelle und der Batterie 82 ist dies nicht trivial. Deswegen wird ein zweistufiges Konzept eingesetzt, auf das in Figur 3 eingegangen wird.

Alternativ kann das Verfahren auch in Bordnetzen mit nur einer Spannungslage, bspw. 12V, eingesetzt werden.

Figur 3 zeigt eine beispielhafte Implementierung eines ersten Fahrzyklus 100 und eines zweiten Fahrzyklus 102. Ein erstes Symbol 104 zeigt eine Plausibilisierung der EBS-Messgrößen, ein zweites Symbol 106 zeigt eine Plausibilisierung der Berechnung des Innenwiderstands Rᵢ der Batterie.

In einem ersten Schritt wird die Korrektheit der Messungen des EBS überprüft. Dabei werden die Messgrößen plausibilisiert, die für die Rᵢ-Bestimmung relevant sind. Diese Plausibilisierung wird einmal je Fahrzyklus durchgeführt.

In einem zweiten Schritt wird die korrekte Berechnung des Rᵢ durch den EBS überprüft. Diese Kontrolle der EBS-Berechnung wird mehrmals im Fahrzyklus durchgeführt, um Fehler im EBS rechtzeitig vor Verletzung des Sicherheitsziels erkennen zu können.

Es ist somit ein zweistufiges Verfahren vorgesehen, auf dessen beide Stufen nachfolgend näher eingegangen wird:
In Stufe 1 erfolgt die Plausibilisierung der Messgrößen des EBS. Zur Berechnung des Innenwiderstandes Rᵢ der Batterie werden u. a. folgende Messgrößen benötigt:
- Strommessung, relevant ist dabei hauptsächlich der Stromsprung, der Offset kann vernachlässigt werden,
- Spannungsmessung, relevant ist dabei hauptsächlich der Spannungssprung, der Offset kann vernachlässigt werden.

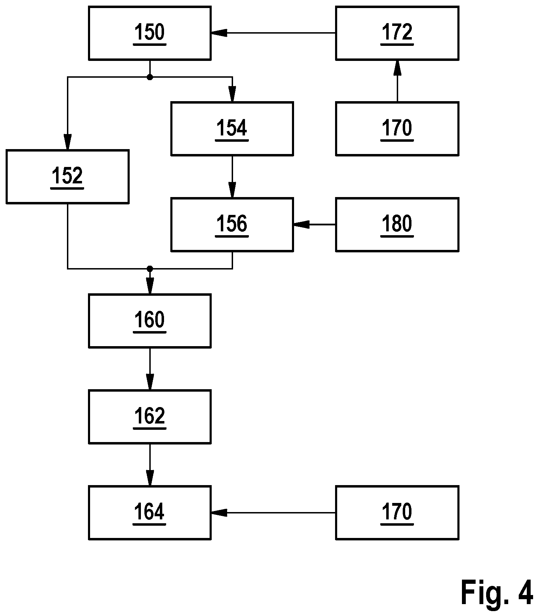

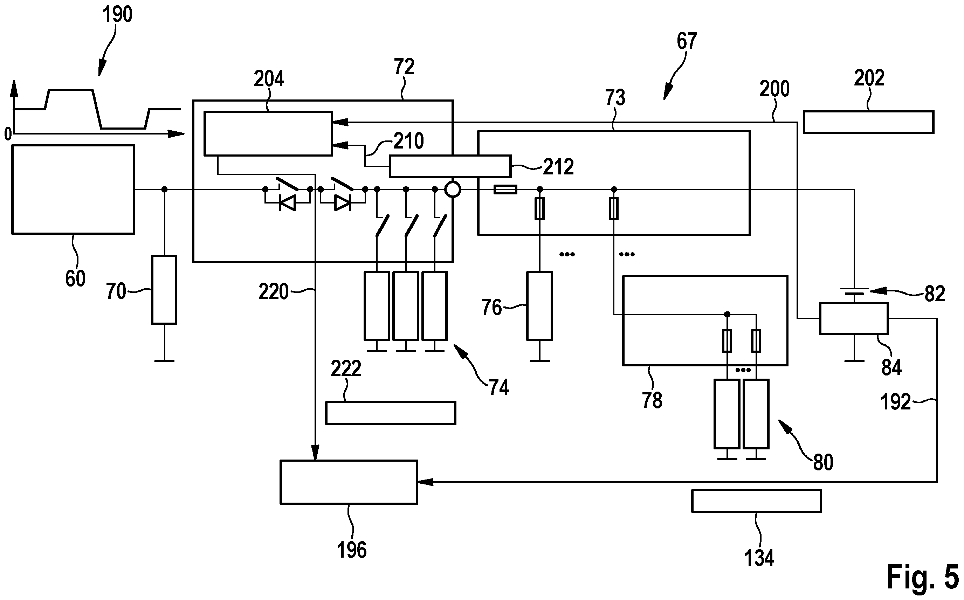

Zu beachten ist, dass fehlerhafte Messungen des EBS bezüglich Strom- und Spannungsdrift dabei durch die Plausibilisierung erkannt werden sollten. Dazu wird das Vorgehen nach Figuren 4 sowie der Signalfluss nach Figur 5 vorgesehen.

Figur 4 zeigt in einem Flussdiagramm einen möglichen Ablauf der Plausibilisierung der EBS-Messgrößen. In einem ersten Schritt 150 erfolgt eine Stromsimulation der Batterie z. B. durch den Gleichspannungswandler. Darauf folgt in einem zweiten Schritt 152 eine Spannungs- und Strommessung durch den elektronischen Lastverteiler (IELV) 154 nach ASIL A(C). Parallel dazu erfolgt in einem Schritt 154 eine Spannungs- und Strommessung durch den EBS nach ASIL B(C) und dann in einem Schritt 156 eine Übertragung der gemessenen Spannungs- und Stromwerte zu dem IELV mit ASIL B(C).

Anschließend berechnet in einem Schritt 160 der IELV die Werte für ΔU_{EBS}, ΔI_{EBS} und ΔU_{IELV}, ΔI_{IELV} nach ASIL C. Dann vergleicht der IELV ΔU_{EBS}, ΔI_{EBS} und ΔU_{IELV}, ΔI_{IELV} nach ASIL C in einem Schritt 162. Wenn der Unterschied der Werte von EBS und IELV einen Schwellwert übersteigt, dann wird ein Status Fehler eingenommen. Anschließend sendet der IELV in einem Schritt 164 den Status zu einer ECU auf einem höheren Level mit ASIL C Eine fehlerhafte Kommunikation muss mit ASIL C vermieden werden.

Eine fehlerhafte Kommunikation des IELV muss in einem parallelen Schritt 170 durch eine ECU auf einem höheren Level mit ASIL C erkannt werden. In dem IELV wird außerdem die regelmäßige Stimulationen, welche Voraussetzung für die Batteriezustandserkennung ist, nach ASIL C überwacht und es erfolgt bei einer fehlerhaften Anregung eine Kommunikation zu einer ECU auf einem höheren Level mit ASIL C. Eine ECU auf einem höheren Level erzeugt eine Maßnahme, bspw. eine Trigger-Anregung oder einen Übergang in einen sicheren Zustand.

Daneben erfolgt in einem Schritt 180 durch den IELV eine Erfassung einer fehlenden oder fehlerhaften Kommunikation des EBS nach ASIL C.

Figur 5 zeigt die Seite mit niedriger Spannungslage 67 aus Figur 2 mit den Signalflüssen zur Verdeutlichung der Plausibilisierung der Messgrößen. Die Darstellung zeigt den angekoppelten Gleichspannungswandler 60, den 12V Verbraucher R_{B,12V} 70, den elektronischen Lastverteiler (IELV) 72, den konventionellen Leistungsverteiler bzw. die Sicherungsbox 73, die sicherheitsrelevanten Verbraucher 74, den sicherheitsrelevanten Verbraucher 76, den Leistungsverteiler 78, die sicherheitsrelevanten/Post-Crash/NSRV Verbraucher 80, die Batterie B₁ 82 und den der Batterie B₁ 82 zugeordneten EBS 84. Ein Graph 190 verdeutlicht ein Stromsignal, das vom Gleichspannungswandler vorgegeben wird.

Es wird nachfolgend näher auf die Signalflüsse eingegangen, wobei die Numerierung keine zeitliche Abfolge festlegen soll. Ein erster Signalfluss 192 sendet als Information 194 U, I nach ASIL B(C) von dem EBS 84 zu einem übergeordneten Steuergerät 196, bspw. einem elektronischen Energiemanagement (EEM). Ein zweiter Signalfluss 200 sendet als Information 202 U, I mit ASIL B(C) von dem EBS 84 zu dem IELV 72, in dem eine Plausibilisierung 204 von U, I nach ASIL C erfolgt. Ein dritter Signalfluss 210 sendet als Information 212 U, I nach ASIL A(C) zu der Plausibilisierung 204 in dem IELV 72. Stromwerte werden typischerweise aus Haupt-/Nebenschaltmessstellen ermittelt, die Spannung wird typischerweise an einem Punkt im IELV ermittelt. Von der Plausibilisierung 204 erfolgt ein vierter Signalfluss 220 mit der Information 222, ob die Werte plausiblel sind, zu dem übergeordneten Steuergerät 196.

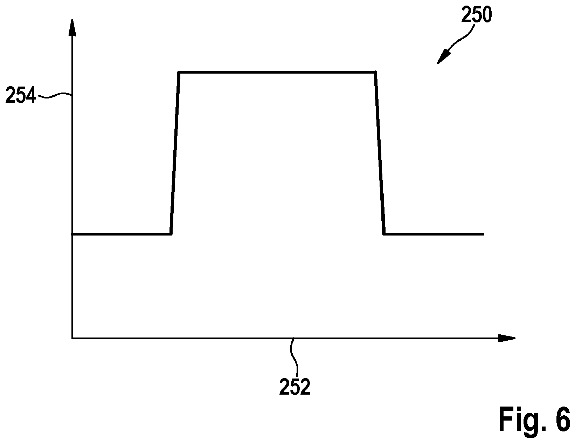

Figur 6 zeigt in einem Graphen 250, an dessen Abszisse 252 die Zeit t und an dessen Ordinate 254 der Strom I aufgetragen ist, einen beispielhaften Strompuls des Gleichspannungswandlers.

Um den Zustand der Batterie überwachen zu können, ist eine gewisse Anregung, bspw. in Form von Strompeaks, erforderlich. Je nach Betriebsstrategie und Fahrzeugnutzung kommen diese Anregungen im Bordnetz sehr selten vor, weswegen der Zustand der Batterie nicht lückenlos überwacht werden kann. Um diese Diagnoselücken zu schließen, wird eine aktive Anregung auf das Energiebordnetz gebracht. Dies ist bspw. durch den Gleichspannungswandler möglich, der für eine definierte Dauer eines definierten Strompulses, z. B. einen Strom-Rechteckpuls nach Figur 6, auf das Energiebordnetz bringt. Der IELV muss mit ASIL C sicherstellen, dass die Anregung in ausreichender Häufigkeit vorkommt, andernfalls an das übergeordnete Steuergerät melden, d. h. Korrektheit der Nachricht ASIL C, Überwachung der Kommunikation durch das übergeordnete Steuergerät mit ASIL C.

Die Anregung kann auch anders erreicht werden, bspw. durch Zu- und Abschaltung von Hochlastverbrauchern.

Der EBS sendet seine ASIL B (C) Rohsignale U_{EBS}, I_{EBS}, T_{EBS} an den intelligenten elektrischen Leistungsverteiler. Der elektrische Leistungsverteiler misst U_{IELV}, I_{IELV}, T_{IELV} an bestimmten Betriebspunkten, d. h. bei Durchführung eines Testpulses, wie dies vorstehend beschrieben ist, in ASIL A(C) Qualität. Im intelligenten elektronischen Lastverteiler werden Deltagrößen ermittelt und die Deltagrößen des EBS mit den Deltagrößen des IELV verglichen, mit ASIL C Integrität. Auf diese Weise kann festgestellt werden, ob die Messung des EBS fehlerfrei ist und die Messsignale des EBS werden dadurch auf ASIL C Integrität angehoben.

Alternativ sendet der EBS bereits Deltawerte an den IELV. Dieser ermittelt seinerseits die Deltawerte und vergleicht diese.

Beim Vergleich der Messwerte ist als maßgebliche Störgröße der Strom am abgehenden konventionellen Leistungsverteiler, siehe Figur 2, zu berücksichtigen, da dieser nicht direkt gemessen werden kann. Beim Vergleich der Strom- und Spannungsdeltas auf IELV- und EBS-Seite wird ein vorhandener Konstantstrom durch den konventionellen Verteiler durch die Deltaberechnung eliminiert. Lediglich zum Zeitpunkt des Testpulses vorhandene Lastschwankungen wirken sich störend auf den Vergleich aus. Um den Einfluss solcher Störungen so weit wie möglich zu eliminieren, können folgende Maßnahmen ergriffen werden:
- Durchführung des Tests während einer Initialisierungsphase oder im Nachlauf des Fahrzeugs, um die Anzahl der aktiven Systeme bzw. Aktuatoren auf ein Minimum zu reduzieren.
- Erzeugung eines Testsignals, bei dem mehrere Flanken auswertbar sind. Zufällig auftretende Schaltflanken auf Seiten des konventionellen Lastverteilers wirken sich nicht gleichermaßen auf alle Flanken gleichermaßen aus, somit kann bei Vergleich mehrerer Flanken hintereinander und Anwendung einer 1 aus N Auswahl die Störung gefiltert werden.
- Falls die gemessenen Daten eines Tests nicht konsistent sind, kann der Test mehrfach wiederholt werden, um die Zuverlässigkeit der Aussage zu erhöhen.
- Die Störung durch eine Lastflanke am konventionellen Leistungsverteiler kann zu fälschlich erkannten Defekten in der Messkette führen, was eine Überführung in den sicheren Zustand bewirkt. D. h. das System ist grundsätzlich sicher, ein Fehldiagnose führt lediglich zu einer Reduzierung der Verfügbarkeit.

Der IELV sendet an das übergeordnete Steuergerät 196 die Information, dass der EBS 84 korrekt misst. Alternativ kann in einer einfacheren Ausführung vorgesehen sein: Es erfolgt eine Messung der bisher unbekannten Stromabflüsse durch zusätzliche Messstellen bzw. eine Messung des Batteriestroms.

Die Messung der physikalischen Größen im IELV kann dabei direkt am Anschluss des Batteriepfades im IELV oder durch Berechnung gemäß Knoten-und Maschenregeln im IELV berechnet werden. Des Weiteren können Sens-Leitungen oder ähnliches mit direkter Messung an der Batterie vorgesehen sein.

Durch die hierin vorgestellte Plausibilisierung der Messgrößen des EBS wird sichergestellt, dass die Signale, die zur Bewertung des Leistungsvermögens der Batterie notwendig sind, in ASIL C Qualität vorliegen.

Nachfolgend wird auf Stufe 2 eingegangen, in der eine Plausibilisierung der EBS-Performancegrößen erfolgt.

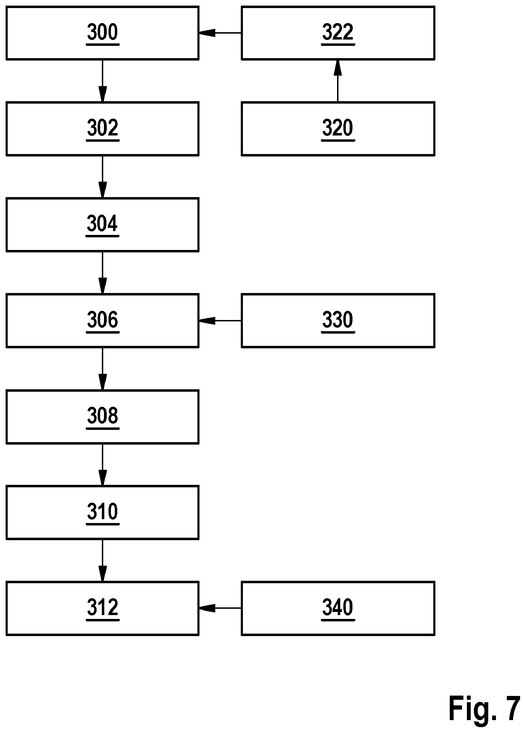

Figur 7 zeigt hierzu in einem Flussdiagramm einen Ablauf zur Überprüfung der Korrektheit des Innenwiderstands Rᵢ der Batterie. In einem ersten Schritt 300 erfolgt eine Stromstimulation der Batterie durch den Gleichspannungswandler. In einem anschließenden Schritt 302 erfolgt eine Spannungs- und Strommessung durch den EBS nach ASIL B(C). Dann berechnet in einem Schritt 304 der EBS den Rᵢ mit ASIL B(C). In einem Schritt 306 erfolgt dann eine Übertragung von gemessenen Spannungs- und Stromwerten und R_{iEBS} zu dem IELV nach ASIL B(C). Dann berechnet in einem Schritt 308 IELV R_{IELV} basierend auf der EBS-Spannungsmessung und EBS-Strommessung nach ASIL A(C). Anschließend vergleicht in einem Schritt 310 der IELV R_{iEBS} und R_{IELV}. Dann sendet in einem Schritt 312 der IELV einen Status zu einer ECU auf einem höheren Level mit ASIL C. Eine fehlerhafte Kommunikation muss mit ASIL C verhindert werden.

Daneben erfolgt in einem Schritt 320, 340 eine Erfassung einer fehlenden oder fehlerhaften Kommunikation zu einer ECU auf einem höheren Level mit ASIL C. Der IELV überwacht in einem Schritt 322 eine ausreichend häufige Stimulation mit ASIL C, es erfolgt eine Kommunikation zu einer ECU auf höherem Level mit ASIL C bei einer fehlenden Stimulation. Es erfolgt eine Maßnahme eines ECU höheren Levels, bspw. ein Triggern einer Anregung oder ein Übergang in den sicheren Zustand.

Daneben erfasst in einem Schritt 330 der IELV eine fehlende oder ungültige Kommunikation des EBS mit ASIL C.

Zu beachten ist, dass Rᵢ in kurzen Zeitintervallen ermittelt werden sollte, um bspw. Zellkurzschlüsse erkennen zu können. Der Ablauf dieser Plausibilisierung ist in Figur 7 dargestellt. Auch für die Rᵢ-Bestimmung ist eine ausreichende Anregung im Bordnetz bzw. Energiebordnetz erforderderlich. Die Anregung kann, wie dies vorstehend beschrieben ist, durchgeführt werden. Der EBS ermittelt Strom- und Spannungsverläufe und berechnet den Rᵢ. Der EBS sendet sowohl Rohdaten als auch den berechneten R_{iEBS} an den IELV.

Da die Übertragungsrate des Bussystems, bspw. eines LIN, sehr limitiert ist, werden die Daten im EBS als Paket versendet. Die LIN-Kommunikation ist nicht in der Lage, alle Messdaten in Echtzeit zu übertragen. Der EBS verfügt dafür über einen Erkennungsmechanismus, der erkennt, dass eine Stromflanke auftritt. Daraufhin speichert der EBS die benötigten Strom- und Spannungswerte, ggf. findet eine Filterung der Werte statt. Unabhängig davon berechnet der EBS permanent den Rᵢ.Die Daten sowie der R_{IEBS} werden anschließend als Datenpaket gesendet. Alternativ kann auch jeder einzelne Messwert gesendet werden, bspw. über eine abweichende Kommunikationsschnittstelle.

Der IELV berechnet den R_{iIELV} und ermittelt somit, ob der EBS richtig gerechnet hat. Der IELV sendet den Status, ob Rᵢ in Ordnung ist an ein übergeordnetes Steuergerät, bspw. an ein Energiemanagement.

Um eine genaue Rᵢ-Bestimmung durchführen zu können, sind mehrere Anregungsflanken notwendig. Diese werden an den IELV gesendet und ausgewertet. Um eine diversitäre Redundanz zu erreichen, können im EBS und/oder IELV unterschiedliche Algorithmen zur Bestimmung des Rᵢ eingesetzt werden. Alternativ kann der Algorithmus nach ASIL C entwickelt sein.

Zu beachten ist, dass das vorgestellte Verfahren grundsätzlich auch für andere ASIL Einstufungen eingesetzt werden kann.

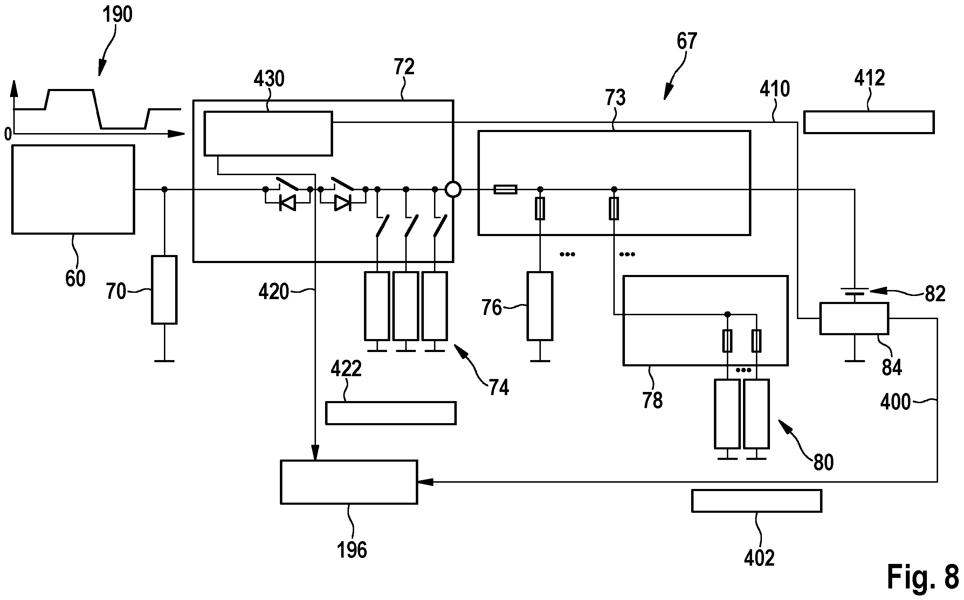

Figur 8 zeigt die Niedervoltseite aus Figur 5 zur Verdeutlichung der Plausibilisierung der Rᵢ-Berechnung. Ein erster Signalfluss 400 trägt als Information 402 Rᵢ nach ASIL B(C). Ein zweiter Signalfluss 410 trägt als Information 412 R_{iEBS}; U, I nach ASIL B(C). Ein dritter Signalfluss 420 trägt als Information 422 einen Hinweis, ob die Werte plausibel sind. In dem IELV 72 erfolgt in 430 eine Berechnung von Ri_{IELV} auf Basis von U, I und eine Plausibilisierung von R_{iEBS} und R_{iIELV} nach ASIL C.

Zu berücksichtigen ist, dass das Verfahren einfacher durchzuführen ist, wenn zwischen der Batterie und dem IELV kein weiterer Lastverteiler angeordnet ist. Dann kann Rᵢ direkt im IELV durchgeführt werden, d. h. eine Messung direkt im IELV mit ASIL C, da die LIN-Kommunikation entfällt. Das gleiche gilt für die Wahl eines anderen Kommunikationssystems mit höheren Datenübertragungen und ggf. Echtzeitfähigkeit. Zudem kann der EBS direkt am IELV angeschlossen sein, der EBS kann auch über ein anderes Steuergerät, z. B. eine Gateway, mit dem IELV kommunizieren.

## Patentansprüche

1. Verfahren zum Betreiben eines Bordnetzes (50), das einen Energiespeicher, wobei diesem Energiespeicher eine Sensor-Recheneinheit zugeordnet ist, und einen elektronischen Lastverteiler (72) aufweist, wobei mit der Sensor-Recheneinheit mindestens eine Messgröße des Energiespeichers erfasst wird und unter Berücksichtigung dieser mindestens einen Messgröße ein Parameter des Energiespeichers berechnet wird, wobei in einem ersten Schritt eine Plausibilisierung der mindestens einen Messgröße und **dadurch gekennzeichnet, dass** in einem zweiten Schritt eine Plausibilisierung der Berechnung durchgeführt wird, wozu der elektronische Lastverteiler (72) eingesetzt wird.

2. Verfahren nach Anspruch 1, bei dem die Plausibilisierung der mindestens einen Messgröße in dem ersten Schritt einmal je Fahrzyklus durchgeführt wird und die Plausibilisierung der Berechnung im zweiten Schritt mehrmals im Fahrzyklus durchgeführt wird.

3. Verfahren nach Anspruch 1 oder 2, bei dem als Energiespeicher eine Batterie (82) verwendet wird, der als Sensor-Recheneinheit ein elektronischer Batteriesensor (84) zugeordnet ist.

4. Verfahren nach Anspruch 3, bei dem als Messgrößen ein Strom und eine Spannung erfasst werden und als Größe der Innenwiderstand der Batterie (82) berechnet wird.

5. Verfahren nach Anspruch 4, bei dem als Messgrößen ein Stromsprung und ein Spannungssprung erfasst werden.

6. Verfahren nach Anspruch 5, bei dem zur Berechnung des Innenwiderstands der Batterie (82) mehrere Anregungsflanken herangezogen werden.

7. Verfahren nach einem der Ansprüche 1 bis 6, das während einer Initialisierungsphase durchgeführt wird.

8. Verfahren nach einem der Ansprüche 1 bis 6, das im Nachlauf eines Fahrzeugs durchgeführt wird.

9. Verfahren nach einem der Ansprüche 1 bis 8, bei dem zur Durchführung des Verfahrens ein Testsignal vorgegeben wird.

10. Verfahren nach einem der Ansprüche 1 bis 9, bei dem Ergebnisse der beiden Plausibilisierungen an eine übergeordnete Recheneinheit weitergegeben werden.

11. Bordnetz mit einem Energiespeicher, dem eine Sensor-Recheneinheit zugeordnet ist, und einem elektronischen Lastverteiler (72), **dadurch gekennzeichnet, dass** das Bordnetz (50) zur Durchführung eines Verfahrens nach einem der Ansprüche 1 bis 10 eingerichtet ist.

12. Bordnetz nach Anspruch 11, das eine Seite mit höherer Spannungslage (51) und eine Seite mit niedriger Spannungslage (67) umfasst, wobei der Energiespeicher und der elektronische Lastverteiler (72)auf der Seite mit niedriger Spannungslage (67) vorgesehen sind.

13. Bordnetz nach Anspruch 11 oder 12, bei dem der Energiespeicher als Batterie (82) und die Sensor-Recheneinheit als elektronischer Batteriesensor (84) ausgebildet ist.

## Claims

1. A method for operating a vehicle electrical system (50) that has an energy store with a sensor computing unit assigned to it, and an electronic load distributor (72), wherein at least one measurement value of the energy store is detected by means of the sensor computing unit, and a parameter of the energy store is calculated by taking into account this at least one measurement value, **characterized in that** in a first step a plausibility check of the at least one measurement value is carried out and that in a second step a plausibility check of the calculation is carried out, for which purpose the electronic load distributor (72) is used.

2. The method according to claim 1, in which the plausibility check of the at least one measurement value in the first step is carried out once per drive cycle and the plausibility check of the calculation in the second step is carried out multiple times in the drive cycle.

3. The method according to claim 1 or 2, in which a battery (82) is used as the energy store, to which battery an electronic battery sensor (84) is assigned as sensor computing unit.

4. The method according to claim 3, in which a current and a voltage are detected as measurement values, and the inner resistance of the battery (82) is calculated as a value.

5. The method according to claim 4, in which a current jump and a voltage jump are detected as measurement values.

6. The method according to claim 5, in which multiple excitation edges are relied on for calculating the inner resistance of the battery (82).

7. The method according to any one of claims 1 to 6, that is carried out during an initialization phase.

8. The method according to any one of claims 1 to 6, that is carried out in the wake of a motor vehicle.

9. The method according to any one of claims 1 to 8, in which a test signal is preset for carrying out the method.

10. The method according to any one of claims 1 to 9, in which the results of the two plausibility checks are passed on to a master computing unit.

11. A vehicle electrical system with an energy store to which a sensor computing unit is assigned, and an electronic load distributor (72), **characterized in that** the vehicle electrical system (50) is configured for carrying out a method according to any of claims 1 to 10.

12. The vehicle electrical system according to claim 11, comprising a side with higher voltage level (51) and a side with a lower voltage level (67), wherein the energy store and the electronic load distributor (72) are provided on the side with lower voltage level (67).

13. The vehicle electrical system according to claim 11 or 12, in which the energy store is designed as a battery (82) and the sensor computing unit is designed as an electronic battery sensor (84).

## Revendications

1. Procédé permettant de faire fonctionner un réseau de bord (50), présentant un accumulateur d'énergie auquel est associée une unité de calcul à capteur, et un répartiteur de charge électronique (72), au moins une grandeur de mesure de l'accumulateur d'énergie étant saisie avec l'unité de calcul à capteur et un paramètre de l'accumulateur d'énergie étant calculé en tenant compte de cette au moins une grandeur de mesure, **caractérisé en ce que** lors d'une première étape, une plausibilisation de la au moins une grandeur de mesure est effectuée, et que lors d'une deuxième étape, une plausibilisation du calcul est effectuée, le répartiteur de charge électronique (72) étant utilisé à cet effet.

2. Procédé selon la revendication 1, dans lequel la plausibilisation de la au moins une grandeur de mesure est effectuée une fois par cycle de conduite lors de la première étape et la plausibilisation du calcul est effectuée plusieurs fois par cycle de conduite lors de la deuxième étape.

3. Procédé selon la revendication 1 ou 2, dans lequel une batterie (82) est utilisée comme accumulateur d'énergie et un capteur de batterie électronique (84) est associé à ladite batterie comme unité de calcul à capteur.

4. Procédé selon la revendication 3, dans lequel un courant et une tension sont saisis comme grandeurs de mesure et la résistance interne de la batterie (82) est calculée comme grandeur.

5. Procédé selon la revendication 4, dans lequel une saute de courant et une saute de tension sont enregistrées comme grandeurs de mesure.

6. Procédé selon la revendication 5, dans lequel plusieurs bords d'excitation sont utilisés pour calculer la résistance interne de la batterie (82).

7. Procédé selon l'une des revendications 1 à 6, mis en oeuvre pendant une phase d'initialisation.

8. Procédé selon l'une des revendications 1 à 6, mis en oeuvre dans le sillage d'un véhicule.

9. Procédé selon l'une des revendications 1 à 8, dans lequel un signal de test est prédéfini pour la mise en oeuvre du procédé.

10. Procédé selon l'une des revendications 1 à 9, dans lequel les résultats des deux plausibilisations sont transmis à une unité de calcul supérieure.

11. Réseau de bord doté d'un accumulateur d'énergie auquel est associée une unité de calcul à capteur et d'un répartiteur de charge électronique (72), **caractérisé en ce que** le réseau de bord (50) est conçu pour mettre en oeuvre un procédé selon l'une des revendications 1 à 10.

12. Réseau de bord selon la revendication 11, comprenant un côté à niveau de tension plus élevé (51) et un côté à niveau de tension plus bas (67), l'accumulateur d'énergie et le répartiteur de charge électronique (72) étant placés sur le côté à niveau de tension plus bas (67).

13. Réseau de bord selon la revendication 11 ou 12, dans lequel l'accumulateur d'énergie est réalisé sous forme de batterie (82) et l'unité de calcul à capteur est réalisée sous forme de capteur à batterie électronique (84).
